# EUROPÄISCHE PATENTSCHRIFT

(11) **EP 1 609 343 B1**
(45) Veröffentlichungstag und Bekanntmachung des Hinweises auf die Patenterteilung: **06.05.2009**
(21) Anmeldenummer: 04703764.3
(22) Anmeldetag: 21.01.2004
(51) Int. Cl.: H05K 7/20, G06F 1/20

(54) **BELÜFTUNGSVORRICHTUNG**
VENTILATION DEVICE
DISPOSITIF DE VENTILATION

(30) Priorität: 28.03.2003 DE 10314167
(43) Veröffentlichungstag der Anmeldung: 28.12.2005
(73) Patentinhaber: SIEMENS AKTIENGESELLSCHAFT, 80333 München (DE)
(72) Erfinder: LEUSCHNER, Klaus, 85591 Vaterstetten (DE)
(74) Vertreter: Maier, Daniel Oliver
(86) Internationale Anmeldenummer: PCT/EP2004/000439
(87) Internationale Veröffentlichungsnummer: WO 2004/086835

(56) Entgegenhaltungen:
- US-A- 4 817 865
- US-A- 6 021 042
- US-B1- 6 340 874

## Beschreibung

### Technisches Gebiet

Die Erfindung betrifft eine Belüftungsvorrichtung zum zwangsweisen Belüften von Baugruppen in einem Baugruppenträger und umfasst wenigstens eine Lüftereinheit, die durch Anschlussleitungen mit einer Stromversorgungseinheit verbunden ist, sowie eine Steuereinheit, zur Überwachung des Belüftungsvorgangs der zumindest einen Lüftereinheit, wobei die Steuereinheit ein Steuerelement im Stromkreis der Anschlussleitungen steuert.

### Stand der Technik

Um Wärme aus einem Baugruppenträger abzuführen werden Ventilatoren verwendet, die eine erzwungene Luftströmung erzeugen und diese an den zu belüftenden Baugruppen vorbei führen wird. In der Regel kommen drehzahlgeregelte elektrische Antriebe zum Einsatz, die von einer Steuereinheit angesteuert werden.

Die Zuverlässigkeit eines Systems mit elektronischen und/oder elektrischen Baugruppen hängt entscheidend von der Funktionsfähigkeit des Belüftungssystems ab. Fällt das Belüftungssystem aus, kommt es zu lokalen Überhitzungen von Bauelementen und in Folge davon zu Funktionsbeeinträchtigungen bzw. zum Ausfall des Systems.

In sicherheitskritischen Systemen ist es üblich, das Belüftungssystem redundant auszuführen. Dabei werden mehrere Ventilatoren parallel betrieben und jeweils von einer redundant ausgelegten Steuerelektronik angesteuert. In der Regel finden geschwindigkeitsgeregelte Elektromotoren Verwendung. Die Geschwindigkeitsregelung erfolgt über ein Schaltelement im Stromkreis der Anschlussleitungen, das beispielsweise durch Pulsweitenmodulation getaktet wird. Auch wenn aus Kostengründen nur an einem Leitantrieb die Drehzahl erfasst und auf die Steuerung zurückgeführt wird, erfordert die redundant ausgelegte Steuerelektronik einen Kostenaufwand, der für viele Anwendungsfälle zu groß ist.

Um die Wärme von elektronischen Baugruppen eines Computers abzuführen, ist beispielsweise aus der Patentschrift US 6,021,042 eine Belüftungsvorrichtung mit zwei parallel geschalteten Ventilatoren bekannt. Jeder Ventilator erzeugt einen Luftstrom, der über eine Mischkammer auf zwei zu belüftende Prozessorbaugruppen gelenkt wird. In der Mischkammer sind Rückschlagklappen so angeordnet, das im Fehlerfall jeder erzeugte Luftstrom jeweils auf eine der zu kühlenden Prozessorbaugruppen gelenkt werden kann. Es gibt Anwendungsfälle, bei denen der mechanische Aufwand für die Mischkammer und die daran angeschlossenen Luftleiteinrichtungen zu groß bzw. der erforderliche Platzbedarf nicht gegeben ist.

Häufig ist es auch so, dass die mechanischen Baukomponenten der Lufterzeugungseinrichtung bereits im Baugruppenträger integriert und herstellerseitig vorgegeben sind. Um die Ausfallsicherheit zu erhöhen, kann anwenderseitig nur die Steuerelektronik redundant ausgeführt werden.

### Darstellung der Erfindung

Eine Aufgabe der vorliegenden Erfindung besteht darin, bei einer Belüftungsvorrichtung der eingangs genannten Art ohne großen Aufwand die Zuverlässigkeit zu verbessern.

Diese Aufgabe wird erfindungsgemäß durch die Merkmale des Patentanspruchs 1 gelöst. Auf vorteilhafte Ausgestaltungen der Erfindung nehmen die Unteransprüche Bezug.

Bei der erfindungsgemäßen Belüftungsvorrichtung ist jeder Baugruppe eine Temperaturüberwachungseinrichtung zugeordnet. Sobald die Betriebstemperatur einer Baugruppe einen vorgegebenen Grenzwert überschreitet, schaltet die Temperaturüberwachungseinrichtung eine Schalteinrichtung durch. Diese Schalteinrichtung liegt im Bypass zu einem Steuerelement, das zur Steuerung der Energiezufuhr der Lüfterantriebe dient. Das temperaturgesteuerte Durchschalten des Bypass bewirkt, dass im Störfall jede Baugruppe individuell geschützt wird, indem die Lüfterantriebe auf maximale Drehzahl geschalten werden und die maximale Kühlwirkung erzeugen. Die erfindungsgemäße Schaltungsanordnung kann mit vergleichsweise günstigen Kosten aufgebaut werden: Die Bypass-Schalteinrichtung kann durch kontaktlose Halbleiterschalter, Reedrelais oder dergleichen gebildet sein. Zur Realisierung der Temperaturüberwachung auf einer Leiterplatte sind integrierte Schaltkreise handelsüblich, die im Fehlerfall ein Ausgangssignal erzeugen, das direkt auf den Steuereingang eines Halbleiterschalters, beispielsweise das Gate eines Feldeffekt-Transistors, geschalten werden kann. Durch die Erfindung wird eine kompakt aufgebaute, kostengünstige Belüftungsvorrichtung geschaffen, die eine vergleichsweise hohe Ausfallsicherheit aufweist.

Es ist günstig, wenn die Schaltelemente der Bypass-Schalteinrichtung jeweils auf der zu schützenden Baugruppe angeordnet sind. Dadurch kann der Übertragungsweg vom Temperatursensor zum Bypass-Schalter kurz gehalten werden.

Ein kompaktes Aufbauen lässt sich dadurch erreichen, indem die einer Baugruppe zugeordnete Temperaturüberwachungseinrichtung und das Schaltelement jeweils zu einer Schaltungseinheit zusammengefasst werden.

Bevorzugt wird eine Anordnung, bei der die Schaltungseinheiten und die Steuereinheit für die Lüfterantriebe auf örtlich getrennten Baugruppen untergebracht sind. Dadurch ist ein unterberechungsfreier Betrieb der Lüfterantriebe möglich, auch wenn die Steuereinheit zu Servicezwecken kurzzeitig entfernt wird.

Hinsichtlich der Herstellungskosten ist es günstig, wenn die einzelnen Schaltelemente jeder Baugruppe jeweils an eine einzige gemeinsame Backplaneleitung geschaltet sind. Dadurch wird mit geringem Aufwand eine sogenannte wired-or Verknüpfung geschaffen, die auf der Rückwandleiterkarte nur geringen Platz beansprucht.

Besonders vorteilhaft ist es, wenn jedes Schaltelement als Halbleiterschaltelement ausgebildet ist. Bevorzugte Anwendung finden Feldeffekt-Leistungs-Transistoren in MOSFET-Technologie.

Eine besonders niedrige Ausfallrate der Belüftungsvorrichtung lässt sich dadurch erreichen, wenn zumindest eine Lüftereinheit von einem bürstenlosen Motor mit integriertem Tachogenerator angetrieben wird. Bei einem bürstenlosen Motor erfolgt die Stromwendung verschleißlos durch elektronische Schaltelemente. Da keine Bürsten vorhanden sind, entsteht beim Kommutierungsvorgang keine Funkenbildung, die elektromagnetische Störungen verursachen könnte.

Mit Vorteil umfasst die Temperaturüberwachungseinrichtung eine Sensordiode, die in einem integrierten Schaltkreis eines elektronischen Bauelementes der Baugruppe integriert ist. Durch diese chipintegrierte Anordnung ist eine Fremdtemperaturüberwachung direkt an jenen Bauelementen möglich, welche die meiste Wärmeentwicklung verursachen. Damit entfallen thermische Zeitkonstanten, die die Erfassung der Temperatur zeitlich verzögern. Prozessoren können durch diese Schaltungsanordnung besonders wirkungsvoll vor Überhitzung geschützt werden.

Wenn die Steuereinheit über einen Bus mit einem Steuercomputer verbunden ist, lässt sich die Belüftung von einem übergeordneten Rechnersystem überwachen. Der Bus kann durch Datenleitungen der Backplane gebildet sein, an die die Baugruppen angeschlossen sind. Das übergeordnete Rechnersystem kann auf einer Baugruppe angeordnet oder in die Steuereinheit integriert sein. Im Fehlerfall, bei dem die Belüftungseinrichtung mit erhöhter Drehzahl und Geräuschentwicklung läuft, kann das Rechnersystem die aktuelle Lüfterdrehzahl abfragen und ggf. entsprechende Alarm- bzw. Steuersignale erzeugen bzw. zur Anzeige bringen. Besonders bevorzugt werden standardisierte Bussysteme, wie der System Management Bus (SMB-Bus), der Intelligent Plattform Management Bus (IPMB-Bus), oder der I²C-Bus.

Die Erfindung lässt sich vorteilhaft bei Telekommunikationseinrichtungen, zur Belüftung von vertikal oder horizontal in einem Baugruppenträger angeordneten Leiterplatten-Baugruppen im CompactPCI-Standard einsetzen.

### Kurzbeschreibung der Zeichnung

Der Gegenstand der Erfindung wird nachfolgend an Hand der Zeichnungen weiter verdeutlicht. Es zeigen:
- Figur 1: eine schematische Darstellung einer Belüftungsvorrichtung gemäß dem Stand der Technik.
- Figur 2: eine schematische Darstellung der erfindungsgemäßen Belüftungsvorrichtung.
- Figur 3: ein Blockschaltbild der erfindungsgemäßen Belüftungsvorrichtung.
- Figur 4: ein bevorzugtes Ausführungsbeispiel der erfindungsgemäßen Belüftungsvorrichtung mit einer Sensordiode zur Temperaturerfassung.
- Figur 5: eine bevorzugte Anordnung der erfindungsgemäßen Belüftungsvorrichtung in einem Baugruppenträger bei der die Bypass-Schaltelemente an eine gemeinsame Leiterbahn auf der Rückwandleiterkarte geschaltet sind.

### Ausführung der Erfindung

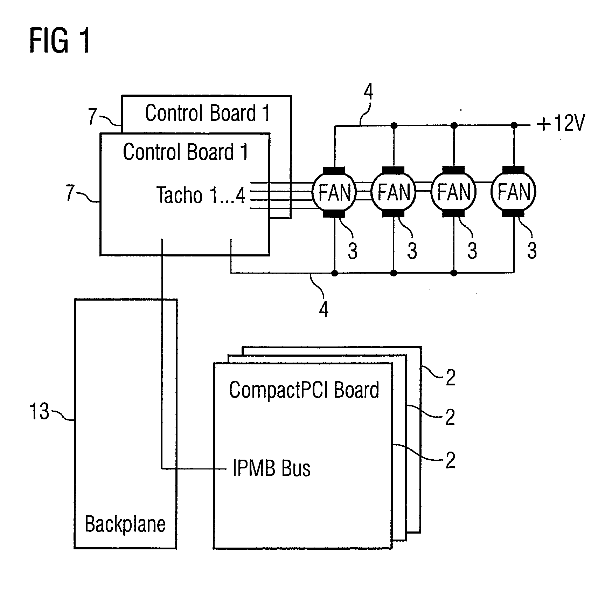

In Figur 1 ist eine schematische Darstellung einer bekannten Belüftungsvorrichtung in einer Ausführung mit vier Lüftern 3 gezeigt. Die von den Lüftern 3 erzeugte Luftströmung wird durch in Figur 1 nicht näher dargestellte Luftleiteinrichtungen auf die zu belüftenden Baugruppen 2 gelenkt. In der Zeichnung sind schematisch drei Baugruppen 2 dargestellt, die in einer gemeinsamen Rückwandleiterkarte eines Baugruppenträgers stecken. Jede Baugruppe 2 ist über einen als Strich dargestellten IPMB Bus mit der Steuereinheit 7 verbunden. Die Überwachung des Belüftungsvorgangs erfolgt dadurch, indem die Lüfter 3 durch rückgekoppelte Tachosignale 1...4 durch die Steuereinheit 7 (Control Board I) in der Drehzahl geregelt werden. Zur Erhöhung der Ausfallsicherheit dient eine zweite Steuereinheit (Control Board II) als Back Up. Um den Belüftungsvorgang an schwankende Umgebungsbedingungen anzupassen, kann die Steuereinheit Temperatursensoren umfassen, welche die Temperatur der Zutrittsluft an den Lüftern messen und in Abhängigkeit davon die Lüfterdrehzahl einstellen. Abweichend von der Darstellung in Figur 1 kann aus Kostengründen auch nur ein Tachogenerator (TG) vorgesehen werden. In diesem Fall dient die Tachospannung dieses Leitantriebs als Regelgröße für den Belüftungsvorgang. Wie eingangs dargestellt, verursacht die redundante Steuerelektronik zusätzliche Kosten, die in bestimmten Anwendungsfällen nicht vertretbar sind.

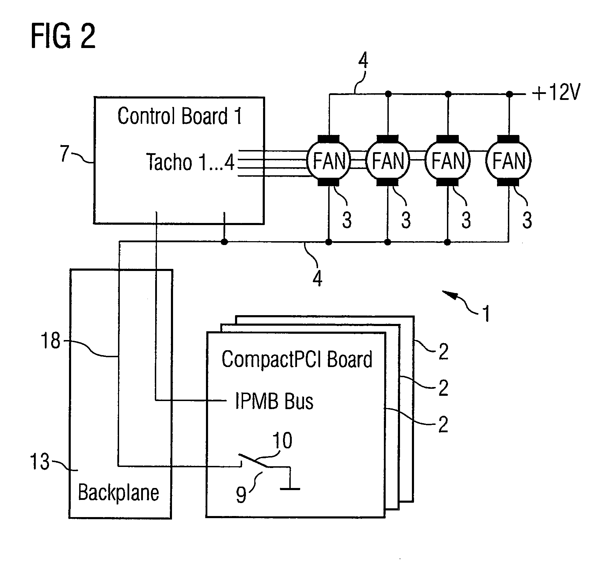

Demgegenüber zeigt Figur 2 in einer schematischen Darstellung die erfindungsgemäße Belüftungsvorrichtung bei der das redundante Steuersystem nicht vorhanden ist. Der Fehlerfall wird durch einen Temperatursensor auf der Baugruppe 2 (Compact PCI Board) erfasst. Ein Schalter mit dem Bezugszeichen 10 schaltet die Anschlussleitung 4 der Lüfterantriebe auf Masse durch. Dadurch wird die Lüfterregelung 7 durch eine Bypass-Schaltung überbrückt. Folge davon ist, dass im Fehlerfall alle vier Ventilatoren 3 an voller Betriebsspannung (Vcc) liegen. Im dargestellten Beispiel ist dies die Betriebsspannung 12 V. Die Lüfterantriebe 3 laufen ungeregelt und mit maximaler Drehzahl.

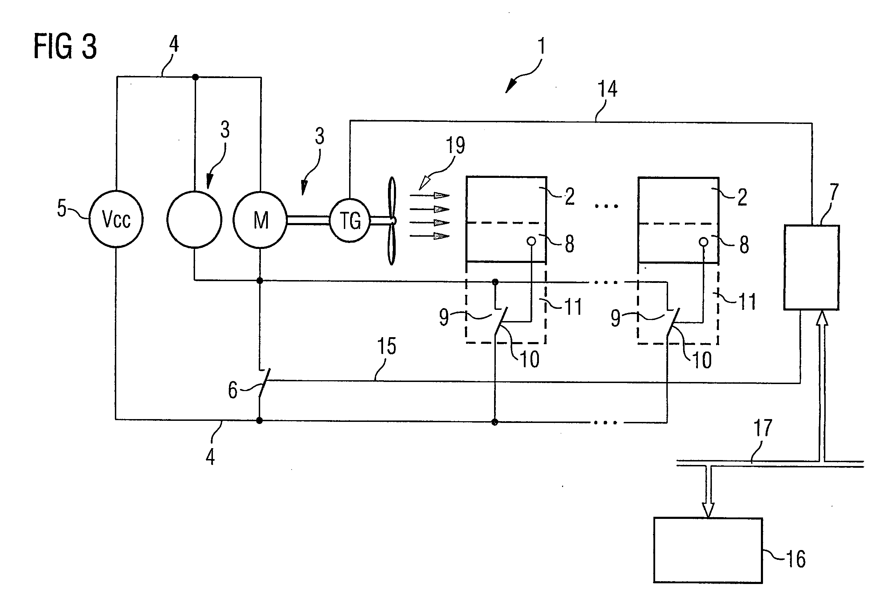

Die Umschaltung im Fehlerfall ist aus dem Blockschaltbild der Figur 3 besser erkennbar. Das erfindungsgemäße Belüftungssystem 1 besteht aus mehreren Lüftereinheiten 3 von denen zwei Lüftereinheiten 3 im Blockschaltbild dargestellt sind. Jeder dieser Ventilatoren 3 erzeugt eine Luftströmung 19 die auf die zu belüftenden Baugruppen 2 gerichtet ist. Die Steuereinheit 7 überwacht diesen Belüftungsvorgang. Hierfür wird die Drehzahl der Ventilatoren durch einen Tachogenerator TG erfasst und über eine Leitung 14 auf die Steuereinheit 7 zurückgeführt. Die Steuereinheit 7 erzeugt eine Stellgröße, die über eine Steuerleitung 15 zum Steuerelement 6 geführt ist. Das Steuerelement 6 ist in den Stromkreis der Anschlussleitungen 4 geschaltet. Die Anschlussleitungen 4 verbinden jede Lüftereinheit 3 mit einer Stromversorgungseinheit 5. Entsprechend dem in der Steuereinheit 7 implementierten Regelalgorithmus wird die Energiezufuhr zu den Lüftereinheiten gesteuert und der Belüftungsvorgang überwacht. Die Energiezufuhr zu den Motoren der Lüfter 3 kann beispielsweise durch Taktung des Ankerstroms gemäß einer Pulsweitenmodulation erfolgen. Tritt nun der Fall ein, dass die Betriebstemperatur auf einer der Baugruppen 2, beispielsweise auf Grund eines Ausfalls der Steuereinheit 7, einen vorgebbaren Schwellwert überschreitet, so wird diese unzulässige Erwärmung von einer Überwachungseinrichtung 8 auf dieser Baugruppe 2 erfasst und der Schalter 10 geschlossen. Der Schalter 10 liegt in einer Parallelschaltung zum Steuerelement 6. Das Schließen des Schalters 10 bewirkt, dass im Fehlerfall sämtliche Antriebe der Lüftereinheiten 3 direkt an die Stromversorgungseinheit 5 geschalten werden. Sie werden mit voller Betriebsspannung betrieben und laufen mit Maximaldrehzahl. Jedes Lüfteraggregat 3 erzeugt eine maximale Luftströmung, welche der Erwärmung entgegenwirkt. Hervorzuheben ist hierbei, dass die Überbrückung des Steuerelementes 6 von jeder der Baugruppen 2 ausgelöst werden kann. Die Bypass-Schaltung ist unabhängig vom Funktionszustand der Steuereinheit 7 und unabhängig von der Drehzahlistwerterfassung. Die temperaturgesteuerte Bypass-Schaltung hat den Vorteil, dass auch dann auf eine verstärkte Belüftung umgeschalten wird, wenn, bei einer Anordnung aus mehreren Lüftern, bei der nur die Tachospannung eines Leitantriebs auf die Steuereinheit 7 zurückgeführt wird, ein Rotor mechanisch blockiert ist.
Im bevorzugten Ausführungsbeispiel der Figur 3 ist das einer Baugruppe 2 zugeordnete Temperaturüberwachungssystem 8 mit dem zugeordneten Schaltelement 10 jeweils zu einer Schaltungseinheit 11 zusammengefasst. Die Schaltungseinheit 11 ist auf der Baugruppe 2 angeordnet. Im Blockschaltbild der Figur 3 ist die Schaltungseinheit durch eine unterbrochene Linie dargestellt.
Die Steuereinheit 7 ist über einen Datenbus 17 mit einem übergeordneten Computersystem 16 verbunden. Auf diese Weise ist es möglich, die Lüfterdrehzahl zu erfassen und auf eine geeignete Anzeigevorrichtungen weiterzuleiten. Es ist ebenfalls möglich, dass sich das Computersystem 16 auf einer oder auf mehreren Baugruppen 2 befindet und über den Datenbus 17 mit der Steuereinheit 7 verbunden ist.

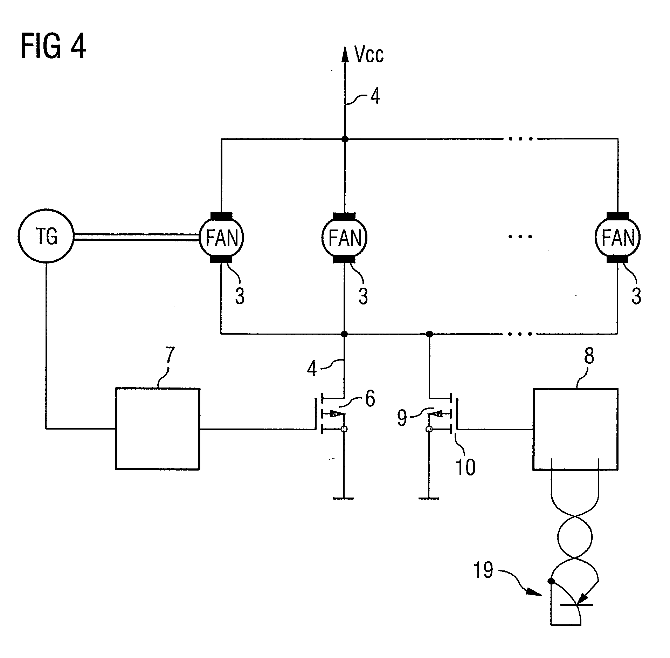

In Figur 4 ist eine weitere bevorzugte Ausführungsform der Erfindung dargestellt. Das Steuerelement 6 und die Schalteinrichtung 9 sind in MOSFET-Technologie ausgeführt. Die Erfassung der Übertemperatur erfolgt über eine Sensordiode 19, deren Messsignal an die Temperaturüberwachungseinrichtung 8 geschaltet ist. Die Sensordiode 19 ist bevorzugt in einen integrierten Schaltkreis eines zu überwachenden elektronischen Bauteils integriert. Dieser Bauteil kann beispielsweise ein Prozessor sein. Da die Erwärmung direkt vor Ort, durch einen chipintegrierten Sensor erfasst wird, kann das Belüftungssystem auf lokale Übertemperatur schnell reagieren, da Verzögerungen auf Grund thermischer Zeitkonstanten weitgehend ausgeschaltet sind.

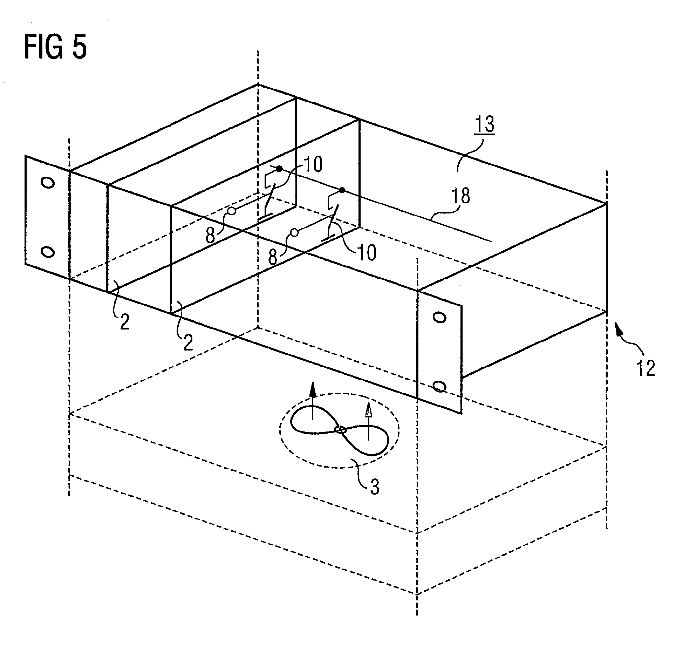

Die Figur 5 zeigt eine besondere Ausführungsform der Erfindung, bei der die Schaltelemente 10 einer jeden Baugruppe 2 mit einer gemeinsamen Leiterbahn 18 der Backplane 13 verbunden sind. Durch die Parallelschaltung der Schalter 10 kann jede Baugruppe 2 die Bypassverbindung durchschalten und im Fehlerfall eine verstärkte Kühlwirkung auslösen.
Die Darstellung der Figur 5 zeigt die Baugruppen 2 in einer vertikalen Einbaulage. Die Lüftereinheiten 3 sind in einer darunter liegenden Baueinheit angeordnet. Selbstverständlich können die Baugruppen 2 im Baugruppenträger auch horizontal und die Lüfter 3 seitlich angeordnet sein.

## Patentansprüche

1. Belüftungsvorrichtung (1) zum zwangsweisen Belüften von Baugruppen (2) in einem Baugruppenträger, umfassend: wenigstens eine Lüftereinheit (3), die durch Anschlussleitungen (4) mit einer Stromversorgungseinheit (5) verbunden ist, eine Steuereinheit (7), zur Überwachung des Belüftungsvorgangs der zumindest einen Lüftereinheit (3), wobei die Steuereinheit (7) ein Steuerelement (6) im Stromkreis der Anschlussleitungen (4) steuert, **dadurch gekennzeichnet, dass** jeder Baugruppe (2) eine Temperaturüberwachungseinrichtung (8) zugeordnet ist welche bei Überschreiten einer Baugruppengrenztemperatur eine, dem Steuerelement (6) parallelgeschaltete, Schalteinrichtung (9) durchschaltet.

2. Belüftungsvorrichtung nach Anspruch 1, **dadurch gekennzeichnet, dass** die Schalteinrichtung (9) Schaltelemente (10) umfasst, die jeweils auf einer Baugruppe (2) angeordnet sind.

3. Belüftungsvorrichtung nach Anspruch 2, **dadurch gekennzeichnet, dass** den Baugruppen (2) zugeordnete Temperaturüberwachungseinrichtungen (8) und Schaltelemente (10) jeweils zu einer Schaltungseinheit (11) zusammengefasst sind.

4. Belüftungsvorrichtung nach Anspruch 3, **dadurch gekennzeichnet, dass** die Schaltungseinheiten (11) und die Steuereinheit (7) im Baugruppenträger (12) örtlich getrennt angeordnet ist.

5. Belüftungsvorrichtung nach einem der vorgehenden Ansprüche, **dadurch gekennzeichnet, dass** die Baugruppen (2) im Baugruppenträger (12) in einer Backplane (13) steckbar angeordnet sind und die Parallelschaltung der Schaltelemente (10) mit dem Steuerelement (6) über eine den Schaltelementen (10) gemeinsame Backplaneleitung (18) hergestellt ist.

6. Belüftungsvorrichtung nach zumindest einem der vorstehenden Ansprüche, **dadurch gekennzeichnet, dass** jedes Schaltelement (10) als Halbleiterschaltelement, besonders bevorzugt als Leistungs-MOSFET, ausgebildet ist.

7. Belüftungsvorrichtung nach zumindest einem der vorstehenden Ansprüche, **dadurch gekennzeichnet, dass** die wenigstens eine Lüftereinheit (3) als Antrieb einen bürstenlosen Motor mit integriertem Tachogenerator (TG) aufweist.

8. Belüftungsvorrichtung nach zumindest einem der vorstehenden Ansprüche, **dadurch gekennzeichnet, dass** jede Temperaturüberwachungseinrichtung (8) zur Temperaturerfassung eine Sensordiode (19) umfasst, die in einem integrierten Schaltkreis eines elektronischen Bauelementes der jeweiligen Baugruppe (2) integriert ist.

9. Belüftungsvorrichtung nach zumindest einem der vorstehenden Ansprüche, **dadurch gekennzeichnet, dass** in einem Baugruppenträger (12) vier Lüftereinheiten (3) angeordnet sind, die gemeinsam von einer Steuereinheit (7) überwacht werden, die als integrierter Controller-Baustein ausgebildet ist.

10. Belüftungsvorrichtung gemäß einem der vorstehenden Ansprüche, **dadurch gekennzeichnet, dass** die Steuereinheit (7) über einen Bus (17) mit einem Steuerungscomputer (16) verbunden ist, wobei der Bus besonders bevorzugt als System Management Bus (SMB-Bus), Intelligent Plattform Management Bus (IPMI-Bus) oder I²C-Bus ausgebildet ist.

11. Baugruppenträger für Leiterplatten-Baugruppen beinhaltend zumindest eine Belüftungsvorrichtung nach zumindest einem der Ansprüche 1 bis 10.

## Claims

1. Ventilation device (1) for forcedly ventilating modules (2) mounted in a subrack, said ventilation device comprising:
at least one fan unit (3) connected to a power supply unit (5) by means of connecting leads (4), a control unit (7) for monitoring the ventilation operation of the at least one fan unit (3), wherein the control unit (7) controls a control element (6) arranged in the electrical circuit of the connecting leads (4), **characterised in that** each module (2) is assigned a temperature monitoring device (8) which through-connects a switching device (9) connected in parallel to the control element (6) if a module limit temperature is exceeded.

2. Ventilation device according to claim 1, **characterised in that** the switching device (9) comprises switching elements (10) which in each case are arranged on a module (2).

3. Ventilation device according to claim 2, **characterised in that** temperature monitoring devices (8) assigned to the modules (2) and switching elements (10) are combined in each case to form a switching unit (11).

4. Ventilation device according to claim 3, **characterised in that** the switching units (11) and the control unit (7) are arranged physically separate from one another in the subrack (12).

5. ventilation device according to one of the preceding claims, **characterised in that** the modules (2) in the subrack (12) are arranged in a pluggable manner in a backplane (13) and the parallel connection of the switching elements (10) with the control element (6) is established via a backplane line (18) common to the switching elements (10).

6. Ventilation device according to at least one of the preceding claims, **characterised in that** each switching element (10) is embodied as a semiconductor switching element, particularly preferably as a power MOSFET.

7. Ventilation device according to at least one of the preceding claims, **characterised in that** the at least one fan unit (3) has a brushless motor with integrated tachogenerator (TG) as a drive.

8. Ventilation device according to at least one of the preceding claims, **characterised, in that** in order to measure the temperature each temperature monitoring device (8) includes a sensor diode (19) which is integrated in an integrated circuit of an electronic component of the respective module (2).

9. Ventilation device according to at least one of the preceding claims, **characterised in that** four fan units (3) are arranged in a subrack (12) and are monitored jointly by a control unit (7) which is embodied as an integrated controller module.

10. Ventilation device according to one of the preceding claims, **characterised in that** the control unit (7) is connected to a control compute (16) via a bus (17), with the bus being particularly preferably embodied as a System Management Bus (SMB bus), Intelligent Platform Management Bus (IPMI bus) or I²C bus.

11. Subrack for printed circuit board modules including at least one ventilation device according to at least one of claims 1 to 10.

## Revendications

1. Dispositif de ventilation (1) pour la ventilation forcée de modules (2) dans un châssis équipes, comprenant:
au moins une unité de ventilateur (3) qui est reliée à une unité d'alimentation en courant électrique (5) via des lignes de raccordement (4), une unité de commande (7) pour la surveillance du processus de ventilation de l'au moins une unité de ventilateur (3), dans lequel l'unité de commande (7) commande un élément de commande (6) dans le circuit électrique des lignes de raccordement (4), **caractérisé en ce qu'**une installation de surveillance de température (8) est affectée à chaque module (2), laquelle connecte une installation de commutation (9) montée en parallèle avec l'élément de commande (6) en cas de dépassement d'une température limite de modules.

2. Dispositif de ventilation selon la revendication 1, **caractérisé en ce que** l'installation de commutation (9) comprend des éléments de commutation (10) qui sont respectivement disposés sur un module (2).

3. Dispositif de ventilation selon la revendication, 2, **caractérisé en ce que** des installations de surveillance de température (8) affectées aux modules (2) et des éléments de commutation (10) sont respectivement groupés en une unité de commutation (11).

4. Dispositif de ventilation selon la revendication 3, **caractérisé en ce que** les unités de commutation (11) et l'unité de commande (7) sont disposées dans le châssis équipes (12), de manière séparée dans l'espace.

5. Dispositif de ventilation selon l'une des revendications précédentes, **caractérisé en ce que** les modules (2) sont disposées de manière enfichable dans le châssis équipe (12) dans une backplane (13) et le montage en parallèle des éléments de commutation (10) avec l'élément de commande (6) est produit par une ligne backplane (18) commune aux éléments de commutation (10).

6. Dispositif de ventilation selon au moins l'une des revendication précédentes, **caractérisé en ce que** chaque élément de commutation (10) est réalisé en tant qu'élément de commutation à semi-conducteur, de manière particulièrement préférée en tant que MOSFET de puissance.

7. Dispositif de ventilation selon au moins l'une des revendications précédentes, **caractérisé en ce que** l'au moins une unité de ventilateur (3) présente un moteur sans balais à générateur d'impulsions (TG) intégré en tant qu'entraînement.

8. Dispositif de ventilation selon au moins l'une des revendication précédentes, **caractérisé en ce que** chaque instillation de surveillance de température (8) pour la saisie de la température comprend une diode capteur (19) qui est intégrée à un circuit intégré d'un composant électronique du module (2) correspondant.

9. Dispositif de ventilation selon au moins l'une des revendication précédentes, **caractérise en ce que** quatre unités de ventilateurs (3) sont disposées dans un châssis équipes (12), surveillées ensemble par une unité de commande (7) réalisée en tant que composant de contrôle intégré.

10. Dispositif de ventilation conformément à l'une des revendications précédente, **caractérisé en ce que** l'unité de commande (7) est reliée à un ordinateur de commande (16) via un bus (17), dans lequel le bus est, de manière particulièrement préférée, réalisé en tant que System Management Bus (bus-SMB), Intelligent Plattform Management Bus (bus-IPMI) ou bus-I²C.

11. Châssis équipes pour des modules de cartes de circuits imprimés contenant au moins un dispositif de ventilation selon au moins l'une des revendications 1 à 10.
